# EUROPEAN PATENT APPLICATION

(11) **EP 0 628 984 A1**
(43) Date of publication of application: **14.12.1994**
(21) Application number: 94201585.0
(22) Date of filing: 03.06.1994
(51) Int. Cl.: H01J 37/26, G03H 5/00

(54) **Method for examining object structures in an electron beam apparatus**

(30) Priority: 10.06.1993 EP 93201652
(71) Applicant: PHILIPS ELECTRONICS N.V., 5621 BA Eindhoven (NL)
(72) Inventor: Kruit,Pieter, c/o Int, Octrooibureau B.V., NL-5656 Eindhoven (NL)
(74) Representative: Bakker, Hendrik

(57) **Abstract**

A method for examining object structures in an electron beam apparatus utilizes two mutually coherent electron beams to produce standing-wave illumination of an object. The two beams form an interference pattern in or near the surface of an object to be examined. The direction and line pattern pitch of this interference pattern can be adapted to the crystal structure of the object and the phase and amplitude information of said structure can be determined.

## Description

The invention relates to a method for examining object structures in a electron beam apparatus by means of two mutually coherent electron beams. The invention also relates to a electron beam apparatus for carrying out such a method.

Document EP 472 235 discloses a method which utilizes focus variation reconstruction to observe the phase and amplitude distribution in the wave function of a electron beam emanating from a specimen in a transmission electron microscope. Although this method also aims to gather information about object structures, it does not utilize mutually coherent electron beams and is appropriate only for transmission electron microscopy.

Prior art document Appl. Phys. Left. 59(19), November 4, 1991, pages 2372-2374, discloses a method which utilizes two mutually coherent electron beams in order to generate a hologram, notably to examine both phase ad amplitude of a electron beam having passed through a object.

Both methods cited exhibit substantial advantages over direct imaging, but both suffer from some intrinsic limitations. The principal limitations of said holography method are the fact that an area of interest should be situated near a region where a electron beam can pass without interaction, and the fact that a substantial amount of information is lost due to chromatic aberration of the electron optical system used. Furthermore, an apparatus for carrying out the method requires some fundamental adaptations, point information of a specimen becomes delocalized due to spherical aberration, and the method requires the use of a image detector with a number of detector elements which substantially exceeds the number of pixels to be recorded. The principal limitations of the in-focus variation method consist in that no phase contrast can be obtained in the range of low spatial frequencies and that a substantial amount of information in the rage of high spatial frequencies is lost due to chromatic aberrations. Further problems occur in that point information becomes delocalized due to the fact that information of a large number of images (as may as ten or even more) must be combined. Non-linear effects tend to impose time-consuming iterative calculation methods for image reconstruction.

It is inter alia an object of the present invention to overcome the described restrictions and difficulties; to this end, a method of the kind set forth according to the invention is characterized in that the two mutually coherent beams are applied to a common part of the object, in order to generate a interference pattern in a plane of the object being examined, and that resultant signals carrying information correlated with the object structure are detected.

A method according to the invention employs a reference beam which impinges on, or passes through, the object at the same location as a primary beam. The reference beam is tilted through a predetermined angle such that in conjunction with the primary beam or with a beam diffracted from the primary beam a interference pattern is generated. From this interference pattern signals carrying information concerning the structure of the object are detected. If the reference beam is collinear with a beam diffracted from the primary beam, phase and amplitude information can be observed in a image plane of the object.

Generally speaking, diffraction phenomena of the reference beam also have to be considered. Diffraction or scattering processes of the two beams can be considered to be totally independent of one another, for example resulting in two diffraction patterns in a backfocal plane of an objective lens. There in the two diffraction patterns can interfere if the two illuminating beams are mutually coherent.

In a preferred embodiment a first electron beam is applied to an object, a reference electron beam being applied to the object in a direction in line with the direction of a electron beam which is diffracted from the first electron beam so as to form a combined beam in conjunction with the reference beam, the electron current in the combined beam being measured as a function of the relative phase difference between the diffracted beam and the reference beam in order to determine both amplitude and phase of the diffracted electron beam.

This method, being a direct alternative for the prior art holographic method and the off-focus method, offers phase and amplitude information without incurring the drawbacks of said known methods. A structure in the form of a CCD camera can be used for position-sensitive measurement of the beam current. If the appropriate measurements of the local beam current in the combined beam are executed, all information for phase and amplitude investigation will become available without image reconstruction or image integration being required.

In a preferred embodiment the measurement is executed with the aid of a Fourier transform computation. This computation is applied to a image which is to be generated by the combined beam in a image plane of the object. Signal enhancement can be realized by stopping the zero-order diffracted beam of the first electron beam; this can be realized by means of, for example a slit-shaped aperture. Similarly, a diffracted beam from the reference beam, which could have a reverse effect on the signals to be measured, such as the beam diffracted in the direction of the zero-order beam of the first illuminating beam, can also be stopped by means of a aperture.

When a object to be examined is illuminated by the two mutually coherent beams forming an interference pattern on the object, signals other than the elastically scattered beams mentioned above can also be detected. For example, backscattered electrons, inelastically scattered electrons, X-rays or Auger electrons can be detected. The inelastically scattered electrons can be filtered according to amount of energy lost in the object.

If the object is a crystal with an atomic spacing d in the y-direction, according to the invention a interference pattern having lines with a pitch d can be produced on the object surface. If the interference lines are oriented and located so that the electrons are incident on the atoms of the crystal, a signal, for example an X-ray signal, will be greater than when the electrons are incident between the atoms of the crystal. This enables detection of the number of a specific kind of atoms having a relative spacing d and detection of the position of these atoms relative to the position of the illuminating interference pattern.

It is to be noted that the latter method to some extent resembles a method known as ALCHEMI, disclosed in Ultra microscopy 24, 1988 pp. 125-142, by K.M. Krisna. However, according to the ALCHEMI method an interference pattern is created with the aid of the top layer structure of a crystalline object, being the object to be examined. Thus, the ALCHEMI method differs substantially from the method according to the invention and is far less generally applicable, notably because the crystal structure is one of the parameters for forming an interference pattern.

A preferred version enables a more fundamental examination of, for example a crystalline surface structure in that use is made of a measuring method signals **emanating** from said structure are subjected to amplitude or energy discrimination. This method enables determination of the depth origin of notably Auger electrons, thus enabling improved examination of the surface structure.

A preferred embodiment of a apparatus for carrying out a method according to the invention comprises, for example a rotatable electron biprism or a rotatable crystal to produce the double beam illumination. An electron biprism should be imaged slightly out of focus on the object in order to establish two interfering beams. A crystal should be imaged on the object with the aid of, for example a double beam selecting aperture and a optical imaging system.

In a further embodiment use is made of a non-rotatable crystal, together with a magnetic lens field for rotating the image of the crystal without exerting disturbing effects on the imaging electron beam.

A further embodiment utilizes a beam tilting device to make both illuminating beams pass symmetrically through an objective lens so as to avoid energy-dependent phase shifts due to chromatic lens aberration.

The signals to be measured can be enhanced by using multipoles and/or pre-compensation of chromatic lens aberration in the crystal and further optical elements.

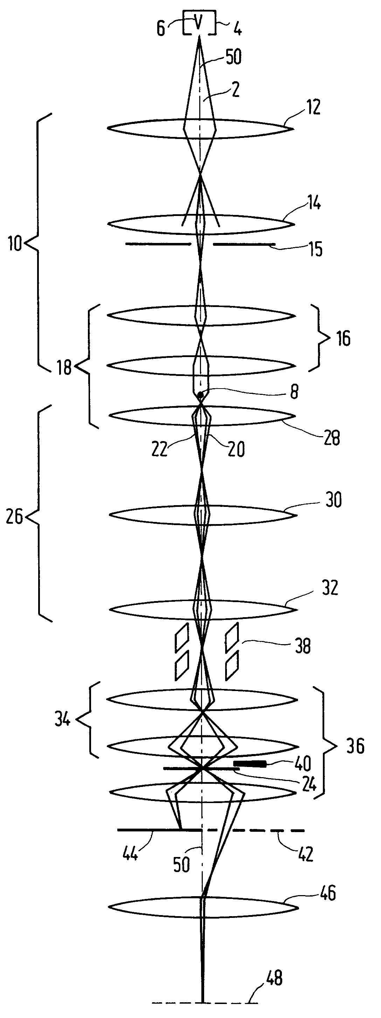

Some embodiments of the invention will be described in detail hereinafter with reference to the accompanying drawing, in which the sole figure shows diagrammatically a transmission electron microscope suitable for carrying out the invention.

The drawing shows an electron beam 2 emitted by an electron gun 4 which is preferably constructed as a field emission gun with an electron-emitting tip 6. The electron beam is directed towards an electron beam splitting device 8, such as a electron biprism or a crystal acting as such, by means of an illuminating system 10 which in this embodiment comprises two condenser lenses 12 and 14 ad a top part 16 of a first "twin" lens system 18. A "twin" lens system per se is disclosed in US 4306149. A beam stopping diaphragm 15 may be added to the condenser system. Two electron beams 20 and 22 emerge from the beam splitting system 8 and an interference line pattern will be formed when the two beams cross. These two electron beams are directed towards a object 24 by means of a second illumination system 26 which in this case comprises a bottom part 28 of the first "twin" lens system 18, two condenser lenses 30 and 32, and a top part 34 of a second "twin" lens system 36. Excitation of the condenser lenses 30 and 32 controls the line pitch of the interference pattern. The second illumination system 26 can be activated in such a way that the interference pattern is rotated without changing the line pitch. In the present embodiment this is achieved by using condenser lenses comprising a double magnetic gap and two excitation coils. Deflection coils 38 determine the position of the illuminated zone on the object being examined. At the same time the deflection coils 38 determine the relative phase of the two illuminating beams 20 and 22. The present embodiment also comprises an X-ray detector 40 which may be replaced by or complemented with a electron detector. Also shown is a diffraction plane 42 of the system in which a beam stop 44 as well as a lens 46 which forms part of a conventional TEM system can be arranged in the imaging or diffraction mode of operation. The two beams cross once more in a plane 48. In a preferred mode of operation diffraction patterns of a object are detected in a plane 42, or imaged at an enlarged scale in a plane 48, depending on the relative phase of the two illuminating beams, and hence on the phase shift between the two illuminating beams, giving general information on the object.

In a further mode of operation signals emerging from the object, such as X-rays, Auger electrons, secondary or reflected electrons, are detected as a function of the phase difference between the two illuminating beams. This examination produces additional information of, for example a certain type of atoms in a crystal, be it only with a comparatively small signal-to-noise ratio.

In a further mode of operation a magnified image of an object is formed in which the amplitudes of Fourier components are determined as a function of the relative phase of the two illuminating beams. In this method it is desirable to direct the reference beam and the diffracted beam along the optical axis 50 by using a tilt-deflection coil system forming part of known illumination systems.

## Claims

1. A method for examining object structures in a electron beam apparatus by means of two mutually coherent electron beams, characterized in that the two mutually coherent electron beams are applied to a common part of the object in order to generate a interference pattern, and that resultant signals carrying information correlated with the object structure are detected.

2. A method as claimed in Claim 1, characterized in that a first electron beam is applied to a object and a reference electron beam is applied to the object in a direction collinear with the direction of a electron beam diffracted from the first electron beam so as to form a combined beam in conjunction herewith, the electron current in the combined beam being measured as a function of the relative phase differences between the diffracted beam and the reference beam in order to determine both amplitude ad phase of the diffracted electron beam.

3. A method as claimed in Claim 2, characterized in that a reference beam is applied through the object in order to generate a interference pattern with the diffracted beam in an image plane of the object, the amplitude of said interference pattern, derived from a Fourier transform of the image, being expressed as a function of the relative phase difference between the diffracted beam and the reference beam.

4. A method as claimed in Claim 2 or 3, in which a zero- order diffracted beam derived from the first electron beam is stopped by a aperture.

5. A method as claimed in Claim 2, 3 or 4, characterized in that a diffracted beam, derived from the reference beam, which would give, by interference with the zero-order beam of the primary beam, a similar interference pattern in an image plane of the object, is stopped by an aperture.

6. A method as claimed in Claim 1, characterized in that a interference pattern is produced on the object and signals which are characteristic of the atomic structure of the object are detected as a function of the position of the interference pattern on the object.

7. An electron beam apparatus for carrying out a method as claimed in any one of the preceding Claims, characterized in that it comprises a rotatable electron biprism which is imaged slightly out of focus on the object in order to achieve standing wave illumination.

8. An electron beam apparatus for carrying out a method as claimed in any one of the Claims 1 to 4, characterized in that it comprises a rotatable crystal, a double beam selecting aperture and an optical system for imaging the crystal on the object in order to achieve double beam illumination.

9. An electron beam apparatus for carrying out a method as claimed in any one of the Claims 1 to 4, characterized in that it comprises a non-rotatable crystal and aperture ad means for generating a magnetic field between said crystal and the object in order to rotate the image of the crystal without influencing the imaging, the magnification or the focusing.

10. An electron beam apparatus as claimed in Claim 7, 8 or 9, characterized in that it comprises a beam tilting device such that the diffracted beam and the reference beam pass symmetrically through a objective lens, avoiding energy-dependent relative phase shifts in said lens due to chromatic aberration.

11. An electron beam apparatus as claimed in Claim 7, 8 or 9, characterized in that it includes multipole lenses.

12. An electron beam apparatus as claimed in Claim 7, 8, 9, 10 or 11, wherein chromatic aberration of the objective lens is compensated for by chromatic effects in the crystal and/or further optical elements.
